# EUROPEAN PATENT SPECIFICATION

(11) **EP 4 415 209 B1**
(45) Date of publication and mention of the grant of the patent: **17.12.2025**
(21) Application number: 23872717.6
(22) Date of filing: 29.06.2023
(51) Int. Cl.: H02J 7/00, H01M 10/42, G01R 31/396, G01R 31/382, G01R 31/371, G01R 19/165, H01M 10/48

(54) **BATTERY CONTROL DEVICE FOR RESPONDING TO LOSS OF COMMUNICATION SITUATION, AND ENERGY STORAGE SYSTEM COMPRISING SAME**
BATTERIESTEUERUNGSVORRICHTUNG ZUR REAKTION AUF DEN VERLUST EINER KOMMUNIKATIONSSITUATION UND ENERGIESPEICHERSYSTEM DAMIT
DISPOSITIF DE COMMANDE DE BATTERIE POUR RÉPONDRE À UNE PERTE DE SITUATION DE COMMUNICATION, ET SYSTÈME DE STOCKAGE D'ÉNERGIE COMPRENANT CELUI-CI

(30) Priority: 27.09.2022 KR 20220122226; 13.02.2023 KR 20230018655
(43) Date of publication of application: 14.08.2024
(73) Proprietor: LG Energy Solution, Ltd., Seoul 07335 (KR)
(72) Inventor: PARK, Jeong Seok, Daejeon 34122 (KR); SONG, Youngdoo, Daejeon 34122 (KR); HWANG, Yunseong, Daejeon 34122 (KR)
(74) Representative: Plasseraud IP
(86) International application number: PCT/KR2023/009136
(87) International publication number: WO 2024/071591

(56) References cited:
- EP-A1- 3 809 554
- JP-B2- 6 008 403
- KR-A- 20170 056 061
- KR-A- 20180 037 722
- KR-A- 20210 004 216
- KR-A- 20210 015 503
- US-A1- 2017 253 140

## Description

### [Technical Field]

The present invention relates to a battery control apparatus and an energy storage system including the same, an, and more particularly, to a battery control apparatus capable of stably operating the energy storage system in a loss of communication situation and an energy storage system including the same.

### [Background Art]

A secondary battery is a battery that can be recharged and reused even after being discharged. The secondary battery can be used as an energy source for small devices such as mobile phones, tablet PCs and vacuum cleaners, and also used as an energy source for medium and large devices such as an energy storage system (ESS) for automobiles and smart grids.

The secondary battery is applied to a system in a form of an assembly such as a battery module in which a plurality of battery cells are connected in series and parallel or a battery pack in which battery modules are connected in series and parallel according to system requirements.

An integrated control device (or upper control device) in an energy storage system monitors and controls battery assemblies based on battery state information such as state of charge (SOC) collected from the battery assemblies. An example of a control device in an energy storage system can be found for instance in KR 2018 0037722 A or JP 6 008403 B2. Here, if a specific battery assembly experiences a loss of communication (LOC), the integrated control device is unable to receive battery state information from the corresponding battery assembly, and accordingly, the control the energy storage system becomes impossible. In this case, the operation of the energy storage system must be stopped to carry out maintenance on a module experiencing a loss of communication. Meanwhile, in the case of an energy storage system which employs lithium iron phosphate (LFP) batteries, it is necessary to fully charge or fully discharge battery assemblies so that the battery assemblies are connected in parallel to each other when the whole battery assemblies are of the same SOC.

In order to solve these problems of the prior art, an appropriate control solution is required to stably operate the energy storage system without stopping the energy storage system when a loss of communication occurs in a specific battery assembly.

### [Detailed Description of the Invention]

### [Technical Problem]

To obviate one or more problems of the related art, embodiments of the present disclosure provide a battery control apparatus capable of stably operating an energy storage system without stopping the energy storage system when a loss of communication occurs in a specific battery assembly.

To obviate one or more problems of the related art, embodiments of the present disclosure also provide a battery control method using the battery control apparatus.

To obviate one or more problems of the related art, embodiments of the present disclosure also provide an energy storage system including the battery control apparatus.

### [Technical Solution]

The present invention provides an energy storage system as defined by independent claim 1 and a battery control method as defined by independent claim **12.** Preferred embodiments are defined in the appended dependent claims.

Tn energy storage system includes a plurality of battery management systems (BMSs) provided in correspondence to a plurality of batteries, respectively; and an upper control apparatus configured to collect state information on the plurality of batteries from the plurality of BMSs and to monitor or control the plurality of batteries based on the collected state information.

Here, the upper control apparatus is configured to, upon the state information of a first battery being not received from a first BMS due to a loss of communication, select a second battery from among a plurality of batteries based on previously stored history information of batteries and use the state information of the second battery as the state information of the first battery.

The upper control apparatus may be configured to keep monitoring or controlling the plurality of batteries without stopping operation of the energy storage system even if the state information of the first battery is not received from the first BMS by using the state information of the second battery as the state information of the first battery.

The upper control apparatus may be configured to receive state information of the second battery from a second BMS during a period in which the state information of the first battery is not received and to record the received state information of the second battery as state information of the first battery.

The upper control apparatus may be configured to, upon the state of charge (SOC) of the first battery being not received from the first BMS, select a second battery among a plurality of batteries based on previously stored history information of the batteries and use the SOC of the second battery as the SOC of the first battery.

The upper control apparatus may be configured to select the second battery using history information about one or more of SOCs, cumulative charge/discharge amount, and temperature values of the batteries.

The upper control apparatus is configured to compare history information of the first battery with history information of batteries other than the first battery, calculate a similarity of a battery with the first battery, and determine a battery having the highest similarity with the first battery as the second battery.

The upper control apparatus may be configured to exclude batteries with a failure history recorded within a predetermined period from comparison among the batteries other than the first battery.

The upper control apparatus may be configured to update a battery having a next higher similarity with the first battery as a second battery, if a failure occurs in the second battery after the second battery is selected.

The upper control apparatus may be configured to: upon not receiving a SOC of the first battery, identify the latest SOC of the first battery or batteries other than the first battery; check whether the identified latest SOC is within a threshold SOC range predefined as an SOC estimation impossible section. Here, the upper control apparatus may determine a battery with the highest similarity to the SOC history information of the first battery as the second battery, if the identified latest SOC is out of the threshold SOC range.

The upper control apparatus may be configured to: upon the number of batteries having the highest similarity with the SOC history information of the first battery being two or more, determine a battery, among the two or more batteries, having the highest similarity with history information on one or more of cumulative charge/discharge amount and a temperature value of the first battery as the second battery.

The upper control apparatus may be configured to: upon the identified latest SOC being within the threshold SOC range, determine a battery having the highest similarity with history information on one or more of cumulative charge/discharge amount and a temperature value of the first battery as the second battery.

The upper control apparatus may be configured to: determine a battery having the highest similarity with the history information on the cumulative charge/discharge amount of the first battery as a second battery. Here, upon the number of batteries having the highest similarity with the history information on the cumulative charge/discharge amount of the first battery being two or more, the upper control apparatus may determine, among the two or more batteries, a battery having the highest similarity with the history information on the temperature value of the first battery as the second battery.

The method of controlling a battery by a battery control apparatus interworking with a plurality of battery management systems (BMSs) provided in correspondence to a plurality of batteries, respectively, the method includes: collecting state information on the plurality of batteries from the plurality of BMSs and monitor or control the plurality of batteries based on the collected state information; upon the state information of a first battery being not received from a first BMS due to a loss of communication, selecting a second battery from among a plurality of batteries based on previously stored history information of batteries; and using the state information of the second battery as the state information of the first battery.

The using the state information of the second battery as the state information of the first battery may include monitoring or controlling the plurality of batteries without stopping operation of the energy storage system even if the state information of the first battery is not received from the first BMS by using the state information of the second battery as the state information of the first battery.

The using the state information of the second battery as the state information of the first battery may include: receiving state information of the second battery from a second BMS during a period in which the state information of the first battery is not received; and recording the received state information of the second battery as the state information of the first battery.

The selecting a second battery may include, upon the state of charge (SOC) of the first battery being not received from the first BMS, selecting a second battery among a plurality of batteries based on previously stored history information of the batteries. Here, the using the state information of the second battery as the state information of the first battery may include using the SOC of the second battery as the SOC of the first battery.

The selecting a second battery may include selecting the second battery using history information about one or more of SOCs, cumulative charge/discharge amount, and temperature values of the batteries.

The selecting a second battery includes: comparing history information of the first battery with history information of batteries other than the first battery so as to calculate a similarity of a battery with the first battery; and determining a battery having the highest similarity with the first battery as the second battery.

The selecting a second battery may include excluding batteries with a failure history recorded within a predetermined period from comparison among the batteries other than the first battery.

The method may further include updating a battery having a next higher similarity with the first battery as a second battery, if a failure occurs in the second battery after the second battery is selected.

The selecting a second battery may include: upon not receiving a SOC of the first battery, identifying the latest SOC of the first battery or batteries other than the first battery; checking whether the identified latest SOC is within a threshold SOC range predefined as an SOC estimation impossible section; and determining a battery with the highest similarity to the SOC history information of the first battery as the second battery, if the identified latest SOC is out of the threshold SOC range.

The selecting a second battery may include: upon the number of batteries having the highest similarity with the SOC history information of the first battery being two or more, determining a battery, among the two or more batteries, having the highest similarity with history information on one or more of cumulative charge/discharge amount and a temperature value of the first battery as the second battery.

The selecting a second battery may include: upon the identified latest SOC being within the threshold SOC range, determining a battery having the highest similarity with history information on one or more of cumulative charge/discharge amount and a temperature value of the first battery as the second battery.

The selecting a second battery may include: determining a battery having the highest similarity with the history information on the cumulative charge/discharge amount of the first battery as a second battery, and, upon the number of batteries having the highest similarity with the history information on the cumulative charge/discharge amount of the first battery being two or more, determining, among the two or more batteries, a battery having the highest similarity with the history information on the temperature value of the first battery as the second battery.

### [Advantageous Effects]

According to embodiments of the present disclosure, the energy storage system can be stably operated without stopping even if a loss of communication situation occurs in a specific battery assembly.

### [Brief Description of the Drawings]

FIG. 1 is a block diagram of a general energy storage system.
FIG. 2 shows a charging characteristic curve of the LFP battery.
FIG. 3 is an operational flowchart of a general operating method of an energy storage system when a loss of communication occurs.
FIG. 4 is a block diagram of an energy storage system according to embodiments of the present invention.
FIG. 5 is an operation flowchart of a battery control method of a battery control apparatus according to embodiments of the present invention.
FIG. 6 is an operation flowchart of a method for selecting a reference battery according to embodiments of the present invention.
FIG. 7 is a reference table for explaining a method for selecting a reference battery according to embodiments of the present invention.
FIG. 8 is a block diagram of a battery control apparatus according to embodiments of the present invention.

100: battery
200 : BMS
300: upper control apparatus
310: storage device
800: battery control apparatus

### [Best Modes for Practicing the Disclosure]

The present invention may be modified in various forms and have various embodiments, and specific embodiments thereof are shown by way of example in the drawings and will be described in detail below.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a"**,** "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a minimum unit that serves to store power and a battery module refers to an assembly in which a plurality of battery cells are electrically connected.

A battery rack refers to a system of a minimum single structure which is assembled by electrically connecting module units, set by a battery manufacturer, and can be monitored and controlled by a battery management apparatus/system (BMS). A battery rack may include several battery modules and a battery protection unit or any other protection device.

A battery bank refers to a group of large-scale battery rack systems configured by connecting several racks in parallel. A bank BMS for a battery bank may monitor and control rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

A battery system controller (BSC) is a top-level control device that controls a battery system including a battery bank or a battery system with a multiple bank level structure.

State of charge (SOC) refers to a current state of charge of a battery, represented in percent points [%], and State of Health (SOH) may be a current condition of a battery compared to its ideal or original conditions, represented in percent points [%].

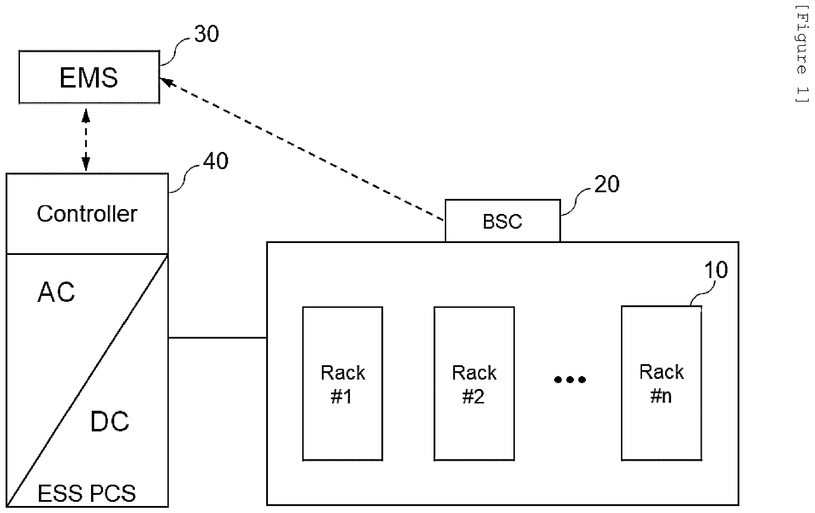

FIG. 1 is a block diagram of a general energy storage system.

In an energy storage system (ESS), typically a battery cell is a minimum unit of storing energy or power. A series/parallel combination of battery cells may form a battery module, and a plurality of battery packs may form a battery rack. In other words, a battery rack can be a minimum unit of a battery system as a series/parallel combination of battery packs. Here, depending on a device or a system in which the battery is used, a battery pack may be referred to as a battery module.

Referring to FIG. 1, a battery rack 10 may include a plurality of battery modules and a battery protection unit (BPU) or any other protection device. The battery rack can be monitored and controlled through a rack BMS (RBMS). The RBMS may monitor a current, a voltage and a temperature, among others, of each battery rack to be managed, calculate a state of charge (SOC) of the battery based on monitoring results, and control charging and discharging of the battery rack.

The battery protection unit (BPU) is a device for protecting the battery rack from an abnormal current and a fault current in the battery rack. The BPU may include a main contactor (MC), a fuse, and a circuit breaker (CB) or a disconnect switch (DS). The BPU may control a battery system rack by rack through on/off controlling the main contactor (MC) based on a control from the Rack BMS. The BPU may also protect the battery rack from a short circuit current using a fuse in the event of a short circuit. As such, the battery system can be controlled through a protection device such as a BPU or a switchgear.

A battery system controller (BSC) 20 is located in each battery section which includes a plurality of batteries, peripheral circuits, and devices to monitor and control objects such as a voltage, a current, a temperature, and a circuit breaker. The battery system controller is an uppermost control apparatus in a bank level battery system including a plurality of battery racks. The battery system controller may also be used as a control apparatus in a battery system having a plurality of bank level structures.

A power conversion system (PCS) 40 installed in each battery section performs charging/discharging based on a charge/discharge command (e.g., a charge or discharge command) from the energy management system (EMS) 30. The power conversion system (PCS) 40 may include a power conversion unit (DC/AC inverter) and a controller. The output of each BPU may be connected to the PCS 40 through a DC bus, and the PCS 40 may be connected to a power grid. In addition, the EMS(or Power Management System (PMS)) 30 may manage the overall energy storage system (ESS).

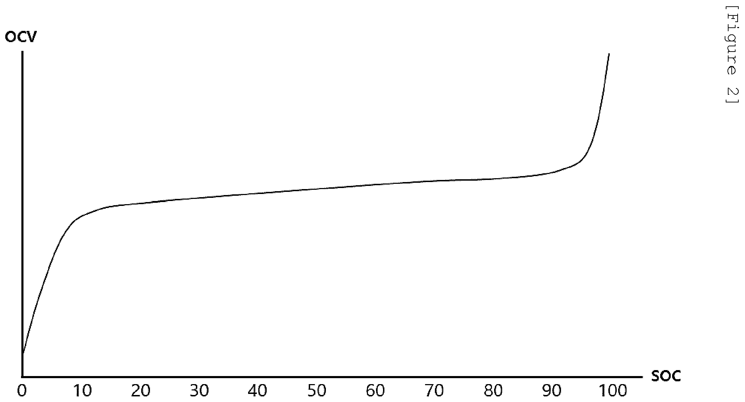

FIG. 2 shows a charging characteristic curve of an LFP battery.

Carbon materials are mainly used as an anode active material of lithium secondary batteries whereas lithium-containing cobalt oxide (LiCoO2) is mainly used as a cathode active material and lithium-containing manganese oxides (LiMnO2, LiMn2O4, etc.) and lithium-containing nickel oxide (LiNiO2) are also being considered.

Recently, a lithium iron phosphate (LiFePO4)-based compound has been used as a cathode active material for a lithium secondary battery. A lithium iron phosphate (LFP) battery using lithium iron phosphate as a cathode active material is superior in terms of thermal stability and cost efficiency compared to other types of batteries.

During operation of the energy storage system, balancing control or charge/discharge control may be performed based on SOCs of batteries. Here, a method of measuring an open-circuit voltage value of the battery and estimating the SOC of the battery based on the measured open-circuit voltage value is mainly used, in order to calculate the SOC of a battery.

FIG. 2 shows a charging characteristic curve which represents a correspondence between an open circuit voltage (OCV) and a SOC measured during a battery charging process.

Referring to FIG. 2, the charging characteristic curve of the LFP battery has a voltage plateau in the SOC range of about 10% to about 90%. In the case of an LFP battery having such a plateau characteristic, it is difficult to accurately estimate the SOC in the plateau section, accurate estimation is possible only in a non- plateau section (e.g., a section where the SOC is 90% or more, or a section where the SOC is 10% or less). In other words, in a battery system to which the LFP battery is applied, accurate SOC estimation is possible only in a very limited SOC section.

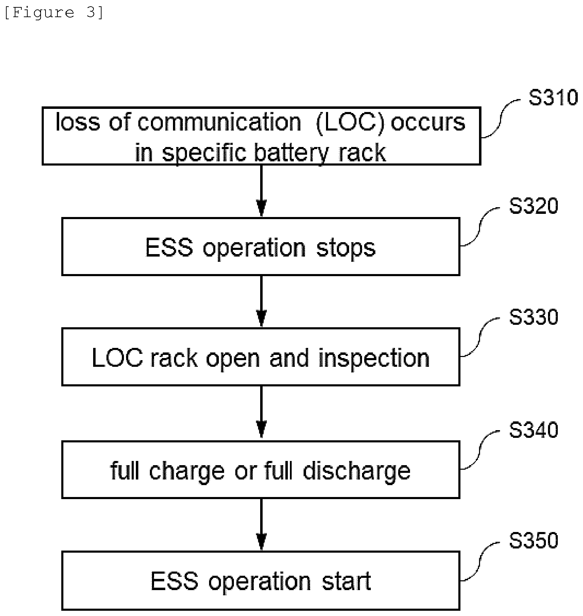

FIG. 3 is an operational flowchart of a general operating method of an energy storage system when a loss of communication occurs.

An upper control apparatus (e.g., BSC or EMS) of the energy storage system may monitor and control battery racks based on SOCs collected from RBMSs. Here, when a loss of communication (LOC) occurs in a specific battery rack (S310), the upper control apparatus cannot receive the SOC from the RBMS of the corresponding battery rack (rack with LOC).

As the SOC of the battery rack in which a loss of communication occurred is omitted, the operation of the energy storage system becomes impossible, the operation of the energy storage system is stopped (S320), and the corresponding battery rack is opened for performing inspection and maintenance work so as to resolve the loss of communication situation (S330).

When the loss of communication state of the corresponding battery rack is resolved, the battery rack may be reconnected to the energy storage system. Here, for stable operation of the energy storage system, the corresponding battery rack needs to be reconnected to the energy storage system when the SOCs of the corresponding battery rack and other battery racks are very similar.

Here, in the case of battery racks with LFP batteries, battery racks need to be fully charged or fully discharged because accurate estimation of SOC is possible only in non-flat sections (e.g., a section with SOC of 90% or more, or a section with SOC of 10% or less) (S340). Then, when the battery racks are electrically connected, the energy storage system may be re-operating (S350).

In other words, when loss of communication occurs in a specific battery rack during operation of the energy storage system, the entire system is stopped and a full charge or full discharge process must be performed, and thus, it takes a considerable amount of time to re-operate the system.

The present invention is presented to solve this problem and relates to a battery control apparatus and an energy storage system including the same, which can stably operate the energy storage system without stopping even if a loss of communication occurs in a specific battery assembly.

Hereinafter, preferred embodiments according to the present invention will be described in detail with reference to the accompanying drawings.

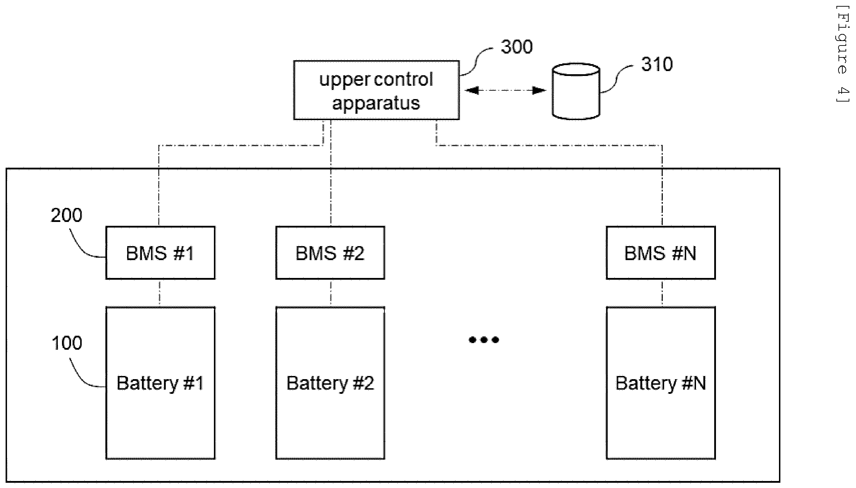

FIG. 4 is a block diagram of an energy storage system according to embodiments of the present invention.

Referring to FIG. 4, the energy storage system according to embodiments of the present invention includes a plurality of batteries 100 and a plurality of battery management systems (BMSs) provided in correspondence to the plurality of batteries, respectively, and for managing and controlling corresponding batteries (200).

The plurality of batteries 100 may be electrically connected to each other in parallel.

In the present disclosure, the battery 100 may mean a battery assembly. In other words, the battery 100 according to the present invention may correspond to a battery module, a battery pack, a battery rack, or a battery bank.

In embodiments, the battery 100 may correspond to a battery assembly including one or more battery cells (e.g., LFP battery cells) having at least a portion of a voltage plateau section in a charging characteristic curve.

The BMS 200 may manage and control its corresponding battery 100 by collecting state information on the corresponding battery 100 and performing a predefined control operation based on the collected state information. Here, the BMS 200 may control charging and discharging of the battery based on the state information of the battery and diagnose whether the battery cells are out of order.

Each of the plurality of BMSs 200 may be connected to an upper control apparatus 300 through a network, transmit battery state information such as SOC of the battery to the upper control apparatus 300, receive control commands from the upper control apparatus 300, and operate based on the received control commands.

The upper control apparatus 300 may collect state information on a plurality of batteries from the plurality of BMSs 200 and monitor or control the plurality of batteries based on the collected state information. Here, the upper control apparatus 300 may correspond to a battery system controller (BSC), an energy management system (EMS), or a power management system (PMS).

When a loss of communication occurs in a specific battery (first battery) and the upper control apparatus 300 cannot receive status information from the BMS (first BMS) corresponding to the battery, the upper control apparatus 300 may operate the energy system by selecting a reference battery (second battery) which is estimated as having state similar to that of the specific battery (first battery) and using state information of the selected reference battery (second battery) as state information of the specific battery with loss of communication (first battery).

In other words, the upper control apparatus 300 may be configured to monitor or control a plurality of batteries by using the state information of the selected reference battery (second battery) as state information of a specific battery with loss of communication (first battery), without stopping the operation of the energy storage system even if state information of the specific battery is not received from a specific BMS (first BMS).

Meanwhile, the upper control apparatus 300 may select a second battery among a plurality of batteries based on history information of the batteries stored in the storage device 310. For example, the upper control apparatus 300 may select a battery having an operating pattern similar to the first battery and determine the battery as the second battery, by using history information on one or more of SOC, cumulative charge/discharge amount, and temperature values of the plurality of batteries stored in the storage device 310.

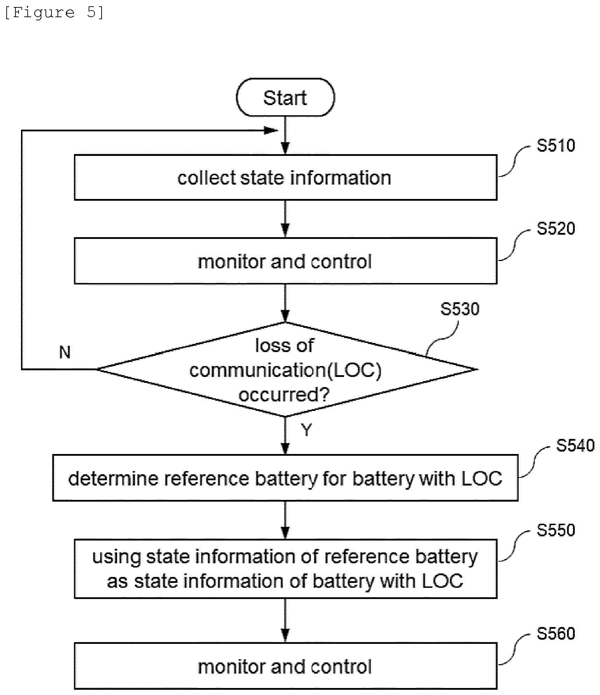

FIG. 5 is an operational flowchart of a battery control method of a battery control apparatus according to embodiments of the present invention.

The control method shown in FIG. 5 may be performed in a battery control apparatus that interworks with a plurality of BMSs provided in correspondence to a plurality of batteries. Here, the battery control apparatus may be an upper control apparatus for a plurality of BMSs, and may correspond to, for example, a battery system controller (BSC), an energy management system(EMS), or a power management system (PMS).

The battery control apparatus may collects state information on a plurality of batteries from a plurality of BMSs (S510). Here, the state information may include one or more of a battery SOC, a voltage value, a current value, a charge/discharge amount, and a temperature value.

The battery control apparatus may monitor or control the plurality of batteries based on the collected state information (S520). For example, the battery control apparatus may control charging and discharging of each battery based on the collected state information.

The battery control apparatus may detect whether a loss of communication has occurred in a specific battery among a plurality of batteries (S530). Here, the battery control apparatus may determine that a loss of communication has occurred in a specific battery when state information is not received from the specific battery.

When a loss of communication occurs in a specific battery (first battery) and state information is not received from the BMS (a first BMS) that manages the battery (Y in S530), the battery control apparatus may designate a reference battery (a second battery) for the battery experiencing a loss of communication (S540).

The battery control apparatus may select a second battery based on history information of batteries stored in the storage device.

The battery control apparatus may determine the second battery among a plurality of batteries by using history information for a predetermined period of time. Here, the history information may include history data on one or more of SOC, cumulative charge/discharge amount, and a temperature value. For example, the battery control apparatus may select a second battery having an operation pattern similar to that of the first battery by using history data on SOC, cumulative charge/discharge amount, or temperature value for a period of 3 days before the occurrence of the loss of communication.

The battery control apparatus may compare history information of the first battery with history information of batteries other than the first battery, calculate a degree of similarity with the first battery, and determine a second battery based on the calculated degree of similarity. For example, the battery control apparatus may calculate a difference between state values (e.g., SOC, cumulative charge/discharge amount, or temperature value) for each time point included in the history data, accumulates the calculated differences, and calculates the similarity based on the accumulated differences. Here, the degree of similarity may be calculated as a higher value as the accumulated difference value becomes lower.

In embodiments, the battery control apparatus may exclude a battery among remaining batteries other than the first battery from comparison, the battery having a failure history recorded within a predetermined period. For example, a battery with a history record of occurrence of an abnormal voltage or detection of an ignition event for a period of up to 3 days from the time of a loss of communication occurrence may be excluded from candidates for the second battery.

The battery control apparatus may determine a battery having the highest similarity with the first battery as the second battery, among the remaining batteries other than the first battery.

The battery control apparatus may monitor or control a plurality of batteries (S560) by using state information of the selected second battery as state information of the first battery (S550) without stopping the operation of the energy storage system. For example, the battery control apparatus may operate the energy storage system by using the SOC of the second battery as a SOC of the first battery.

The battery control apparatus may record the state information of the second battery received from the second BMS as state information of the first battery in a storage device during a period in which the state information of the first battery is not received.

In embodiments, after the second battery is selected, if a failure occurs in the second battery, the battery control apparatus may renew the second battery with a battery having a next higher similarity. For example, when a loss of communication occurs in Rack #1, the energy storage system may be operated such that Rack #2 which has the highest similarity with Rack #1 is selected as the reference battery and the SOC of Rack #2 is used as the SOC of Rack #1. If a failure occurs in Rack #2 during the operation of the energy storage system, the reference battery may be replaced with Rack #3 which shows the next highest similarity with Rack #1 next to Rack #2.

The battery control apparatus may check whether the loss of communication state of the first battery is released. Here, the battery control apparatus may determine that the loss of communication state of the first battery is released when state information is received from the first BMS.

When the loss of communication state with respect to the first battery is released, the battery control apparatus may not use the state information of the second battery as the state information of the first battery, but monitor and control the batteries using state information of each of the batteries.

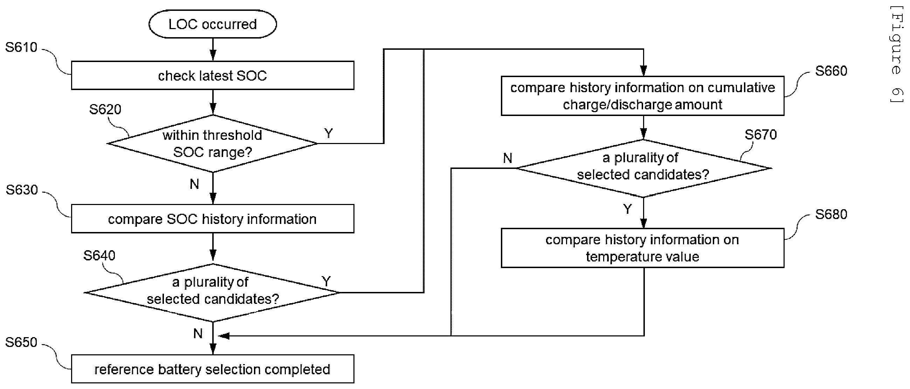

FIG. 6 is an operational flowchart of a method for selecting a reference battery according to embodiments of the present invention.

The battery control apparatus may determine a second battery among a plurality of batteries by using history information for a predetermined period of time. Here, the history information may include history data on one or more of SOC, cumulative charge/discharge amount, and a temperature value.

In embodiments, the battery control apparatus may determine the second battery based on a SOC immediately before a loss of communication occurs and predefined priorities assigned to each history data item. Here, the priorities may be predefined in a sequence starting with SOC, followed by cumulative charge/discharge amount, and a temperature value.

Referring to FIG. 6, when a loss of communication occurs in a specific battery (first battery) and state information is not received from the BMS (first BMS) managing the battery, the battery control apparatus may determine that a loss of communication has occurred in the first battery.

The battery control apparatus may check the latest SOC of the first battery or batteries other than the first battery (S610). For example, if a loss of communication occurs, the battery control apparatus may check the last recorded SOC of each battery in the storage device.

The battery control apparatus may check whether the latest SOC is within a threshold SOC range predefined as an SOC estimation impossible section (S620). Here, the threshold SOC range may be predefined as an SOC section in which the change amount in voltage versus the change amount in SOC is less than or equal to a predefined threshold value in a SOC and voltage correspondence curve of the battery, which may be defined for example, as a section of SOC greater than 10 and less than 90.

If the identified latest SOC is out of the threshold SOC range (N in S620), the battery control apparatus may compare SOC history information of the first battery and SOC history information of other batteries (S630) to determine a battery with the highest similarity. For example, if the latest SOC of the first battery is out of the threshold SOC range (i.e., when a loss of communication occurs while the SOC of the first battery can be estimated), the battery control apparatus may determine the second battery by comparing history information of SOCs which is predefined as the first priority comparison item.

Here, when there is one battery having the highest similarity with the SOC history information of the first battery (N in S640), the corresponding battery may be determined as the second battery (S650).

Meanwhile, when the number of batteries having the highest similarity with the SOC history information of the first battery is two or more (Y in S640), the battery control apparatus may determine a battery, among the two or more batteries, having the highest similarity with history information on one or more of the cumulative charge/discharge amount and a temperature value of the first battery as the second battery (S660 to 680). In other words, if a single reference battery cannot be determined by comparing the SOC history information which is predefined as a first priority comparison item, the battery control apparatus may determine a single reference battery by sequentially comparing the history items of the next priority.

For example, when the number of batteries having the highest similarity with the SOC history information of the first battery is 2 or more, the battery control apparatus may determine the battery having the highest similarity by comparing history information on the cumulative charge/discharge amount (second priority) between the first battery and the other batteries (S660). If the number of batteries having the highest similarity with the history information on the cumulative charge/discharge amount of the first battery is 2 or more (Y in S670), the battery control apparatus may determine the battery having the highest similarity by comparing history information on the temperature value (third priority) of the first battery and history information on the temperature values of the other batteries (S680). Here, when a single battery having the highest similarity is selected, the process of selecting the reference battery may be completed (S650). Meanwhile, if a single battery is not selected even through the comparison of temperature values, a battery located closest to the first battery among batteries having the same degree of similarity may be finally selected as the second battery.

In S620, if the latest SOC identified is within the threshold SOC range (Y in S620), the battery control apparatus may determine a battery having the highest similarity with the history information on one or more of the cumulative charge/discharge amount and the temperature value of the first battery as the second battery (S660 to 680). For example, if the latest SOC of the first battery is within the threshold SOC range (i.e., when a loss of communication occurs in a state in which the SOC of the first battery cannot be estimated), the battery control apparatus may determine a reference battery by sequentially comparing history items of the next priority without comparing SOC history information which is predefined as the first priority.

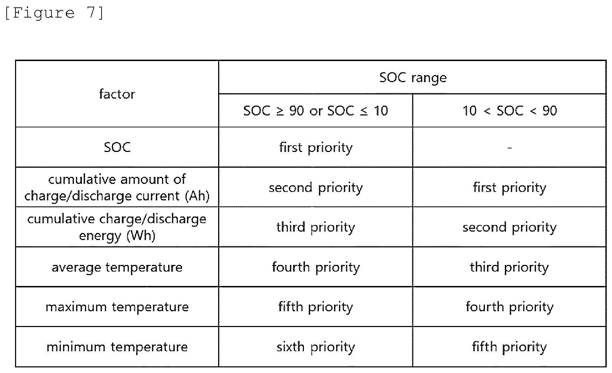

FIG. 7 is a reference table for explaining a method for selecting a reference battery according to embodiments of the present invention.

In embodiments, comparison priorities for each of the SOC estimation impossible section and the history items may be predefined for selection of the reference battery. Here, the battery control apparatus may select a reference battery for a loss of communication battery based on the SOC estimation impossible section stored in the storage device and the comparison priority.

For example, referring to FIG. 7, the SOC estimation impossible section (threshold SOC range) may be defined as a section of SOC greater than 10 and less than 90.

In addition, the history items to be compared may include SOC, cumulative amount of charge/discharge current (Ah), cumulative charge/discharge energy (Wh), average temperature, maximum temperature, and minimum temperature. Here, the comparison priority of history items may be defined in the order of SOC, cumulative amount of charge/discharge current (Ah), cumulative charge/discharge energy (Wh), average temperature, maximum temperature, and minimum temperature.

In the case that it is predefined as shown in the table of FIG. 7, the battery control apparatus may determine a reference battery (second battery) as follows.

If the latest SOC of the first battery is out of the threshold SOC range, the battery control apparatus may sequentially compare history information on the SOC, history information on the cumulative amount of charge/discharge current (Ah), history information on the cumulative charge/discharge energy (Wh), history information on the average temperature, history information on the maximum temperature, and history information on the minimum temperature, until a single reference battery is determined.

If the latest SOC of the first battery is within the threshold SOC range, the battery control apparatus may sequentially compare history information on the cumulative amount of charge/discharge current (Ah), history information on the cumulative charge/discharge energy (Wh), history information on the average temperature, history information on the maximum temperature, and history information on the minimum temperature, until a single reference battery is determined.

Meanwhile, if a single battery is not selected as a result of comparing the history items, a battery located closest to the first battery among batteries having the same degree of similarity may be finally selected as the second battery.

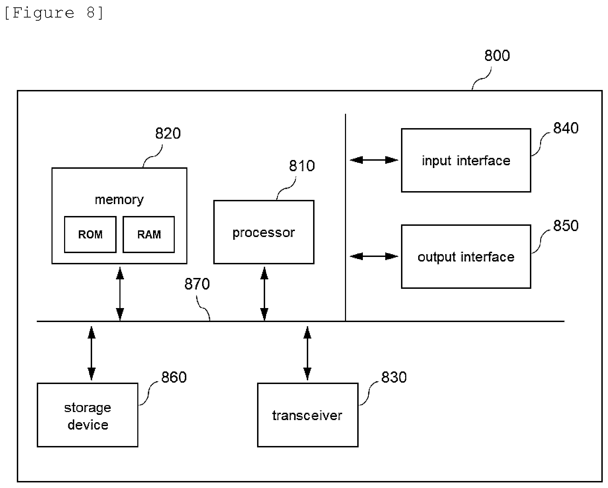

FIG. 8 is a block diagram of a battery control apparatus according to embodiments of the present invention.

The battery control apparatus 800 according to embodiments of the present invention may correspond to an upper control apparatus that is located in an energy storage system and interworks with a plurality of BMSs provided in correspondence with a plurality of batteries. For example, the battery control apparatus 800 may correspond to a battery system controller (BSC), an energy management system (EMS), or a power management system (PMS), or may be implemented by being included in any one of them.

The battery control apparatus 800 may include at least one processor 810, a memory 820 that stores at least one instruction executed by the processor, and a transceiver 830 connected to a network to perform communication.

The at least one instruction may include an instruction to collect state information on the plurality of batteries from the plurality of BMSs and monitor or control the plurality of batteries based on the collected state information; an instruction to, upon the state information of the first battery being not received from a first BMS due to a loss of communication, select a second battery from among a plurality of batteries based on previously stored history information of batteries; and an instruction to use the state information of the second battery as the state information of the first battery.

The instruction to use the state information of the second battery as the state information of the first battery may include an instruction to keep monitoring or controlling the plurality of batteries without stopping operation of the energy storage system even if the state information of the first battery is not received from the first BMS by using the state information of the second battery as the state information of the first battery.

The instruction to use the state information of the second battery as the state information of the first battery may include: an instruction to receive state information of the second battery from a second BMS during a period in which the state information of the first battery is not received; and an instruction to record the received state information of the second battery as the state information of the first battery.

The instruction to select a second battery may include an instruction to, upon the state of charge (SOC) of the first battery being not received from the first BMS, select a second battery among a plurality of batteries based on previously stored history information of the batteries. Here, the instruction to use the state information of the second battery as the state information of the first battery may include an instruction to use the SOC of the second battery as the SOC of the first battery.

The instruction to select a second battery may include an instruction to select the second battery using history information about one or more of SOCs, cumulative charge/discharge amount, and temperature values of the batteries.

The instruction to select a second battery may include: an instruction to compare history information of the first battery with history information of batteries other than the first battery so as to calculate a similarity of a battery with the first battery; and an instruction to determine a battery having the highest similarity with the first battery as the second battery.

The instruction to select a second battery may include an instruction to exclude batteries with a failure history recorded within a predetermined period from comparison among the batteries other than the first battery.

The at least one instruction may further include an instruction to update a battery having a next higher similarity with the first battery as a second battery, if a failure occurs in the second battery after the second battery is selected.

The instruction to select a second battery may include: an instruction to, upon not receiving a SOC of the first battery, identify the latest SOC of the first battery or batteries other than the first battery; an instruction to check whether the identified latest SOC is within a threshold SOC range predefined as an SOC estimation impossible section; and an instruction to determine a battery with the highest similarity to the SOC history information of the first battery as the second battery, if the identified latest SOC is out of the threshold SOC range.

The instruction to select a second battery may include an instruction to: upon the number of batteries having the highest similarity with the SOC history information of the first battery being two or more, determine a battery, among the two or more batteries, having the highest similarity with history information on one or more of cumulative charge/discharge amount and a temperature value of the first battery as the second battery.

The instruction to select a second battery may include an instruction to: upon the identified latest SOC being within the threshold SOC range, determine a battery having the highest similarity with history information on one or more of cumulative charge/discharge amount and a temperature value of the first battery as the second battery.

The instruction to select a second battery may include: an instruction to determine a battery having the highest similarity with the history information on the cumulative charge/discharge amount of the first battery as a second battery, and an instruction to, upon the number of batteries having the highest similarity with the history information on the cumulative charge/discharge amount of the first battery being two or more, determine, among the two or more batteries, a battery having the highest similarity with the history information on the temperature value of the first battery as the second battery.

The battery control apparatus 800 may further include an input interface 840, an output interface 850, a storage device 860, and the like. Respective components included in the battery control apparatus 800 may be connected by a bus 870 to communicate with each other.

Here, the processor 810 may mean a central processing unit (CPU), a graphics processing unit (GPU), or a dedicated processor on which methods according to embodiments of the present invention are performed. The memory (or storage device) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range of the appending claims.

## Claims

1. An energy storage system comprising:
a plurality of battery management systems (200),BMSs, each associated with a respective battery of a plurality of batteries (100); and
an upper control apparatus (300) configured to:
collect state information on the plurality of batteries from the plurality of BMSs;
monitor or control the plurality of batteries based on the collected state information;
upon the state information of a first battery from among the plurality of batteries being not received from a first BMS among the plurality of BMSs due to a loss of communication, select a second battery from the remaining batteries based on previously stored history information of the plurality of batteries and use the state information of the second battery as the state information of the first battery,
wherein to select the second battery the upper control apparatus is configured to:
compare history information of the first battery with history information of batteries other than the first battery and calculate a difference between state values for each time point included in history data of history information;
accumulate the calculated differences over time for each comparison and based on the accumulated differences calculate a degree of similarity with the first battery; and
determine as the second battery a battery having the highest degree of similarity with the first battery, wherein the degree of similarity increases as the accumulated difference value decreases.

2. The energy storage system of claim 1, wherein the upper control apparatus is configured to keep monitoring or controlling the plurality of batteries without stopping operation of the energy storage system even if the state information of the first battery is not received from the first BMS by using the state information of the second battery as the state information of the first battery.

3. The energy storage system of claim 1, wherein the upper control apparatus is configured to receive state information of the second battery from a second BMS among the plurality of BMSs during a period in which the state information of the first battery is not received and to record the received state information of the second battery as state information of the first battery.

4. The energy storage system of claim 1, wherein the upper control apparatus is configured to, upon the state of charge ,SOC, of the first battery being not received from the first BMS, select the second battery among the plurality of batteries based on previously stored history information of the batteries and use the SOC of the second battery as the SOC of the first battery.

5. The energy storage system of claim 4, wherein the upper control apparatus is configured to select the second battery using history information about one or more of SOCs, cumulative charge/discharge amount, and temperature values of the plurality of batteries.

6. The energy storage system of claim 5, wherein the upper control apparatus is configured to exclude batteries with a failure history recorded within a predetermined period from comparison among the batteries other than the first battery.

7. The energy storage system of claim 5, wherein the upper control apparatus is configured to update a battery of the plurality of batteries having a next higher similarity with the first battery as a second battery, if a failure occurs in the second battery after the second battery is selected.

8. The energy storage system of claim 4, wherein the upper control apparatus is configured to:
upon not receiving a SOC of the first battery,
identify the latest SOC of the first battery;
check whether the identified latest SOC is within a threshold SOC range predefined as an SOC estimation impossible section, wherein the SOC estimation impossible section is a section of SOC greater than 10 and less than 90; and
determine a battery from among the plurality of batterie with the highest similarity to the SOC history information of the first battery as the second battery, if the identified latest SOC of the first battery is out of the threshold SOC range.

9. The energy storage system of claim 8, wherein the upper control apparatus is configured to:
upon the number of batteries among the plurality of batteries having the highest similarity with the SOC history information of the first battery being two or more,
determine a battery, among the two or more batteries, having the highest similarity with history information on one or more of cumulative charge/discharge amount and a temperature value of the first battery as the second battery.

10. The energy storage system of claim 8, wherein the upper control apparatus is configured to:
upon the identified latest SOC being within the threshold SOC range,
determine a battery of the plurality of batteries having the highest similarity with history information on one or more of cumulative charge/discharge amount and a temperature value of the first battery as the second battery.

11. The energy storage system of claim 10, wherein the upper control apparatus is configured to:
determine a battery of the plurality of batteries having the highest similarity with the history information on the cumulative charge/discharge amount of the first battery as a second battery, and
upon the number of batteries among the plurality of batteries having the highest similarity with the history information on the cumulative charge/discharge amount of the first battery being two or more, determine, among the two or more batteries, a battery having the highest similarity with the history information on the temperature value of the first battery as the second battery.

12. A battery control method for
a battery control apparatus (800) interworking with a plurality of battery management systems (200),BMSs, each associated with a respective battery of a plurality of batteries(100), the method comprising:
collecting state information (S510) on the plurality of batteries from the plurality of BMSs and monitor or control (S520) the plurality of batteries based on the collected state information;
upon the state information of a first battery from among the plurality of batteries being not received (S530) from a first BMS among the plurality of batteries due to a loss of communication, selecting a second battery from
the reamining batteries based on previously stored history information of the plurality of batteries; and
using the state information of the second battery as the state information of the first battery,
wherein the selecting the second battery comprises:
comparing history information of the first battery with history information of batteries other than the first battery and calculating a difference between state values for each time point included in history data of history information;
accumulating the calculated differences over the time for each comparison and based on the accumulated differences calculating a degree of similarity with the first battery; and
determining as the second battery a battery having the highest degree of similarity with the first battery, wherein the degree of similarity increases as the accumulated difference value decreases.

13. The method of claim 12, wherein the using the state information of the second battery as the state information of the first battery includes monitoring or controlling (S560) the plurality of batteries without stopping operation of the energy storage system even if the state information of the first battery is not received from the first BMS by using the state information of the second battery as the state information of the first battery.

14. The method of claim 12, wherein the using the state information of the second battery as the state information of the first battery includes:
receiving state information of the second battery from a second BMS among the plurality of BMSs during a period in which the state information of the first battery is not received; and
recording the received state information of the second battery as the state information of the first battery.

15. The method of claim 12, wherein the selecting the second battery includes, upon the state of charge ,SOC, of the first battery being not received from the first BMS, selecting the second battery among the plurality of batteries based on the previously stored history information of the batteries, and
wherein using the state information of the second battery as the state information of the first battery includes using the SOC of the second battery as the SOC of the first battery.

16. The method of claim 15, wherein the selecting the second battery includes selecting the second battery using history information including one or more of SOCs, cumulative charge/discharge amount, and temperature values of the batteries.

17. The method of claim 16, wherein the selecting a second battery includes excluding batteries with a failure history recorded within a predetermined period from comparison among the batteries other than the first battery.

18. The method of claim 16, further comprising updating a battery among the plurality of batteries having a next higher similarity with the first battery as the second battery, if a failure occurs in the second battery after the second battery is selected.

19. The method of claim 15, wherein the selecting the second battery includes:
upon not receiving a SOC of the first battery, identifying the latest SOC of the first battery;
checking whether the identified latest SOC is within a threshold SOC range predefined as an SOC estimation impossible section, wherein the SOC estimation impossible section is a section of SOC greater than 10 and less than 90; and
determining a battery from among the plurality of batteries with the highest similarity to the SOC history information of the first battery as the second battery, if the identified latest SOC of the first battery is out of the threshold SOC range.

20. The method of claim 19, wherein the selecting the second battery further includes:
upon the number of batteries having the highest similarity with the SOC history information of the first battery being two or more,
determining a battery, among the two or more batteries, having the highest similarity with history information on one or more of cumulative charge/discharge amount and a temperature value of the first battery as the second battery.

21. The method of claim 19, wherein the selecting the second battery includes:
upon the identified latest SOC being within the threshold SOC range,
determining a battery of the plurality of batteries having the highest similarity with the history information on one or more of cumulative charge/discharge amount and a temperature value of the first battery as the second battery.

22. The method of claim 21, wherein the selecting the second battery includes:
determining a battery of the plurality of batteries having the highest similarity with the history information on the cumulative charge/discharge amount of the first battery as the second battery, and
upon the number of batteries having the highest similarity with the history information on the cumulative charge/discharge amount of the first battery being two or more, determining, among the two or more batteries, a battery of the plurality of batteries having the highest similarity with the history information on the temperature value of the first battery as the second battery.

## Patentansprüche

1. Energiespeichersystem, umfassend:
eine Mehrzahl von Batteriemanagementsystemen (200), BMSs, welche jeweils einer jeweiligen Batterie einer Mehrzahl von Batterien (100) zugeordnet sind; und
eine obere Steuervorrichtung (300), welche eingerichtet ist, zum:
Sammeln von Zustandsinformationen über die Mehrzahl von Batterien von der Mehrzahl von BMSs;
Überwachen oder Steuern der Mehrzahl von Batterien auf Grundlage der gesammelten Zustandsinformationen;
daraufhin, dass die Zustandsinformationen einer ersten Batterie unter der Mehrzahl von Batterien von einem ersten BMS unter der Mehrzahl von BMSs aufgrund eines Kommunikationsausfalls nicht empfangen worden sind, Auswählen einer zweiten Batterie aus den verbleibenden Batterien auf Grundlage von zuvor gespeicherten Historieninformationen der Mehrzahl von Batterien und Verwenden der Zustandsinformationen der zweiten Batterie als die Zustandsinformationen der ersten Batterie,
wobei, um die zweite Batterie auszuwählen, die obere Steuervorrichtung eingerichtet ist, zum:
Vergleichen von Historieninformationen der ersten Batterie mit Historieninformationen von anderen Batterien als der ersten Batterie und Berechnen einer Differenz zwischen Zustandswerten für jeden Zeitpunkt, welcher in Historiendaten von Historieninformationen umfasst ist;
Akkumulieren der berechneten Differenzen über die Zeit für jeden Vergleich und auf Grundlage der akkumulierten Differenzen Berechnen eines Ähnlichkeitsgrads zu der ersten Batterie; und
Bestimmen als die zweite Batterie einer Batterie, welche den höchsten Ähnlichkeitsgrad zu der ersten Batterie aufweist, wobei sich der Ähnlichkeitsgrad erhöht, wenn der akkumulierte Differenzwert abnimmt.

2. Energiespeichersystem nach Anspruch 1, wobei die obere Steuervorrichtung dazu eingerichtet ist, durch ein Verwenden der Zustandsinformationen der zweiten Batterie als die Zustandsinformationen der ersten Batterie die Mehrzahl von Batterien weiterhin zu überwachen oder zu steuern, ohne einen Betrieb des Energiespeichersystems zu stoppen, selbst wenn die Zustandsinformationen der ersten Batterie von dem ersten BMS nicht empfangen werden.

3. Energiespeichersystem nach Anspruch 1, wobei die obere Steuervorrichtung dazu eingerichtet ist, während eines Zeitraums, in welchem die Zustandsinformationen der ersten Batterie nicht empfangen werden, von einer zweiten BMS unter der Mehrzahl von BMSs Zustandsinformationen der zweiten Batterie zu empfangen und die empfangenen Zustandsinformationen der zweiten Batterie als Zustandsinformationen der ersten Batterie aufzuzeichnen.

4. Energiespeichersystem nach Anspruch 1, wobei die obere Steuervorrichtung dazu eingerichtet ist, daraufhin, dass der Ladezustand, SOC, der ersten Batterie von dem ersten BMS nicht empfangen worden ist, auf Grundlage von zuvor gespeicherten Historieninformationen der Batterien die zweite Batterie unter der Mehrzahl von Batterien auszuwählen und den SOC der zweiten Batterie als den SOC der ersten Batterie zu verwenden.

5. Energiespeichersystem nach Anspruch 4, wobei die obere Steuervorrichtung dazu eingerichtet ist, die zweite Batterie unter Verwendung von Historieninformationen über eines oder mehrere aus SOCs, einer kumulativen Lade-/Entlademenge und Temperaturwerten der Mehrzahl von Batterien auszuwählen.

6. Energiespeichersystem nach Anspruch 5, wobei die obere Steuervorrichtung dazu eingerichtet ist, Batterien mit einer innerhalb eines vorbestimmten Zeitraums von einem Vergleich unter den anderen Batterien als der ersten Batterie aufgezeichneten Fehlerhistorie auszuschließen.

7. Energiespeichersystem nach Anspruch 5, wobei die obere Steuervorrichtung dazu eingerichtet ist, eine Batterie der Mehrzahl von Batterien, welche eine nächsthöhere Ähnlichkeit zu der ersten Batterie aufweist, als eine zweite Batterie zu aktualisieren, wenn ein Fehler in der zweiten Batterie auftritt, nachdem die zweite Batterie ausgewählt worden ist.

8. Energiespeichersystem nach Anspruch 4, wobei die obere Steuervorrichtung eingerichtet ist, zum:
daraufhin, dass ein SOC der ersten Batterie nicht empfangen worden ist,
Identifizieren des letzten SOC der ersten Batterie;
Prüfen, ob der identifizierte letzte SOC innerhalb eines Schwellen-SOC-Bereichs liegt, welcher als ein unmöglicher SOC-Schätzabschnitt vordefiniert ist, wobei der unmögliche SOC-Schätzabschnitt ein Abschnitt eines SOC von mehr als 10 und weniger als 90 ist; und
Bestimmen einer Batterie unter der Mehrzahl von Batterien mit der höchsten Ähnlichkeit zu den SOC-Historieninformationen der ersten Batterie als die zweite Batterie, wenn der identifizierte letzte SOC der ersten Batterie außerhalb des Schwellen-SOC-Bereichs liegt.

9. Energiespeichersystem nach Anspruch 8, wobei die obere Steuervorrichtung eingerichtet ist, zum:
daraufhin, dass die Anzahl von Batterien unter der Mehrzahl von Batterien, welche die höchste Ähnlichkeit zu den SOC-Historieninformationen der ersten Batterie aufweisen, zwei oder mehr ist,
Bestimmen einer Batterie unter den zwei oder mehr Batterien, welche die höchste Ähnlichkeit zu Historieninformationen über eines oder mehrere aus einer kumulativen Lade-/Entlademenge und einem Temperaturwert der ersten Batterie aufweist, als die zweite Batterie.

10. Energiespeichersystem nach Anspruch 8, wobei die obere Steuervorrichtung eingerichtet ist, zum:
daraufhin, dass der identifizierte letzte SOC innerhalb des Schwellen-SOC-Bereichs liegt,
Bestimmen einer Batterie der Mehrzahl von Batterien, welche die höchste Ähnlichkeit zu Historieninformationen über eines oder mehrere aus einer kumulativen Lade-/Entlademenge und einem Temperaturwert der ersten Batterie aufweist, als die zweite Batterie.

11. Energiespeichersystem nach Anspruch 10, wobei die obere Steuervorrichtung eingerichtet ist, zum:
Bestimmen einer Batterie der Mehrzahl von Batterien, welche die höchste Ähnlichkeit zu den Historieninformationen über die kumulative Lade-/Entlademenge der ersten Batterie aufweist, als eine zweite Batterie und
daraufhin, dass die Anzahl von Batterien unter der Mehrzahl von Batterien, welche die höchste Ähnlichkeit zu den Historieninformationen über die kumulative Lade-/Entlademenge der ersten Batterie aufweisen, zwei oder mehr ist, Bestimmen unter den zwei oder mehr Batterien einer Batterie, welche die höchste Ähnlichkeit zu den Historieninformationen über den Temperaturwert der ersten Batterie aufweist, als die zweite Batterie.

12. Batteriesteuerverfahren für eine Batteriesteuervorrichtung (800), welche mit einer Mehrzahl von Batteriemanagementsystemen (200), BMSs, zusammenarbeitet, die jeweils einer jeweiligen Batterie einer Mehrzahl von Batterien (100) zugeordnet sind, wobei das Verfahren umfasst:
Sammeln von Zustandsinformationen (S510) über die Mehrzahl von Batterien von der Mehrzahl von BMSs und Überwachen oder Steuern (S520) der Mehrzahl von Batterien auf Grundlage der gesammelten Zustandsinformationen;
daraufhin, dass die Zustandsinformationen einer ersten Batterie unter der Mehrzahl von Batterien von einem ersten BMS unter der Mehrzahl von BMSs aufgrund eines Kommunikationsausfalls nicht empfangen worden sind (S530), Auswählen einer zweiten Batterie aus den verbleibenden Batterien auf Grundlage von zuvor gespeicherten Historieninformationen der Mehrzahl von Batterien; und
Verwenden der Zustandsinformationen der zweiten Batterie als die Zustandsinformationen der ersten Batterie,
wobei das Auswählen der zweiten Batterie umfasst:
Vergleichen von Historieninformationen der ersten Batterie mit Historieninformationen von anderen Batterien als der ersten Batterie und Berechnen einer Differenz zwischen Zustandswerten für jeden Zeitpunkt, welcher in Historiendaten von Historieninformationen umfasst ist;
Akkumulieren der berechneten Differenzen über die Zeit für jeden Vergleich und auf Grundlage der akkumulierten Differenzen Berechnen eines Ähnlichkeitsgrads zu der ersten Batterie; und
Bestimmen als die zweite Batterie einer Batterie, welche den höchsten Ähnlichkeitsgrad zu der ersten Batterie aufweist, wobei sich der Ähnlichkeitsgrad erhöht, wenn der akkumulierte Differenzwert abnimmt.

13. Verfahren nach Anspruch 12, wobei das Verwenden der Zustandsinformationen der zweiten Batterie als die Zustandsinformationen der ersten Batterie ein Überwachen oder ein Steuern (S560) der Mehrzahl von Batterien, ohne einen Betrieb des Energiespeichersystems zu stoppen, selbst wenn die Zustandsinformationen der ersten Batterie von dem ersten BMS nicht empfangen werden, durch ein Verwenden der Zustandsinformationen der zweiten Batterie als die Zustandsinformationen der ersten Batterie umfasst.

14. Verfahren nach Anspruch 12, wobei das Verwenden der Zustandsinformationen der zweiten Batterie als die Zustandsinformationen der ersten Batterie umfasst:
Empfangen von Zustandsinformationen der zweiten Batterie von einem zweiten BMS unter der Mehrzahl von BMSs während eines Zeitraums, in welchem die Zustandsinformationen der ersten Batterie nicht empfangen werden; und
Aufzeichnen der empfangenen Zustandsinformationen der zweiten Batterie als die Zustandsinformationen der ersten Batterie.

15. Verfahren nach Anspruch 12, wobei das Auswählen der zweiten Batterie daraufhin, dass der Ladezustand, SOC, der ersten Batterie von dem ersten BMS nicht empfangen worden ist, ein Auswählen der zweiten Batterie unter der Mehrzahl von Batterien auf Grundlage der zuvor gespeicherten Historieninformationen der Batterien umfasst und
wobei das Verwenden der Zustandsinformationen der zweiten Batterie als die Zustandsinformationen der ersten Batterie ein Verwenden des SOC der zweiten Batterie als den SOC der ersten Batterie umfasst.

16. Verfahren nach Anspruch 15, wobei das Auswählen der zweiten Batterie ein Auswählen der zweiten Batterie unter Verwendung von Historieninformationen umfasst, welche eines oder mehrere aus SOCs, einer kumulativen Lade-/Entlademenge und Temperaturwerten der Batterien umfassen.

17. Verfahren nach Anspruch 16, wobei das Auswählen einer zweiten Batterie ein Ausschließen von Batterien mit einer innerhalb eines vorbestimmten Zeitraums von einem Vergleich unter den anderen Batterien als der ersten Batterie aufgezeichneten Fehlerhistorie umfasst.

18. Verfahren nach Anspruch 16, ferner umfassend ein Aktualisieren einer Batterie unter der Mehrzahl von Batterien, welche eine nächsthöhere Ähnlichkeit zu der ersten Batterie aufweist, als die zweite Batterie, wenn ein Fehler in der zweiten Batterie auftritt, nachdem die zweite Batterie ausgewählt worden ist.

19. Verfahren nach Anspruch 15, wobei das Auswählen der zweiten Batterie umfasst:
daraufhin, dass ein SOC der ersten Batterie nicht empfangen worden ist,
Identifizieren des letzten SOC der ersten Batterie;
Prüfen, ob der identifizierte letzte SOC innerhalb eines Schwellen-SOC-Bereichs liegt, welcher als ein unmöglicher SOC-Schätzabschnitt vordefiniert ist, wobei der unmögliche SOC-Schätzabschnitt ein Abschnitt eines SOC von mehr als 10 und weniger als 90 ist; und
Bestimmen einer Batterie unter der Mehrzahl von Batterien mit der höchsten Ähnlichkeit zu den SOC-Historieninformationen der ersten Batterie als die zweite Batterie, wenn der identifizierte letzte SOC der ersten Batterie außerhalb des Schwellen-SOC-Bereichs liegt.

20. Verfahren nach Anspruch 19, wobei das Auswählen der zweiten Batterie ferner umfasst:
daraufhin, dass die Anzahl von Batterien, welche die höchste Ähnlichkeit zu den SOC-Historieninformationen der ersten Batterie aufweisen, zwei oder mehr ist,
Bestimmen einer Batterie unter den zwei oder mehr Batterien, welche die höchste Ähnlichkeit zu Historieninformationen über eines oder mehrere aus einer kumulativen Lade-/Entlademenge und einem Temperaturwert der ersten Batterie aufweist, als die zweite Batterie.

21. Verfahren nach Anspruch 19, wobei das Auswählen der zweiten Batterie umfasst:
daraufhin, dass der identifizierte letzte SOC innerhalb des Schwellen-SOC-Bereichs liegt,
Bestimmen einer Batterie der Mehrzahl von Batterien, welche die höchste Ähnlichkeit zu den Historieninformationen über eines oder mehrere aus einer kumulativen Lade-/Entlademenge und einem Temperaturwert der ersten Batterie aufweist, als die zweite Batterie.

22. Verfahren nach Anspruch 21, wobei das Auswählen der zweiten Batterie umfasst:
Bestimmen einer Batterie der Mehrzahl von Batterien, welche die höchste Ähnlichkeit zu den Historieninformationen über die kumulative Lade-/Entlademenge der ersten Batterie aufweist, als die zweite Batterie und
daraufhin, dass die Anzahl von Batterien, welche die höchste Ähnlichkeit zu den Historieninformationen über die kumulative Lade-/Entlademenge der ersten Batterie aufweisen, zwei oder mehr ist, Bestimmen unter den zwei oder mehr Batterien einer Batterie der Mehrzahl von Batterien, welche die höchste Ähnlichkeit zu den Historieninformationen über den Temperaturwert der ersten Batterie aufweist, als die zweite Batterie.

## Revendications

1. Système de stockage d'énergie comprenant :
une pluralité de systèmes de gestion de batterie (200), BMS, associés chacun à une batterie respective d'une pluralité de batteries (100) ; et
un appareil de commande supérieur (300) configuré pour :
collecter des informations d'état sur la pluralité de batteries auprès de la pluralité de BMS ;
surveiller ou commander la pluralité de batteries sur la base des informations d'état collectées ;
lorsque les informations d'état d'une première batterie parmi la pluralité de batteries ne sont pas reçues d'un premier BMS parmi la pluralité de BMS en raison d'une perte de la communication, sélectionner une seconde batterie parmi les batteries restantes sur la base d'informations historiques précédemment stockées de la pluralité de batteries et utiliser les informations d'état de la seconde batterie en tant qu'informations d'état de la première batterie,
dans lequel pour sélectionner la seconde batterie, l'appareil de commande supérieur est configuré pour :
comparer des informations historiques de la première batterie avec des informations historiques de batteries autres que la première batterie et calculer une différence entre des valeurs d'état pour chaque point temporel compris dans des données historiques d'informations historiques ;
accumuler les différences calculées au fil du temps pour chaque comparaison et, sur la base des différences accumulées, calculer un degré de similitude avec la première batterie ; et
déterminer en tant que seconde batterie une batterie ayant le plus grand degré de similitude avec la première batterie, dans lequel le degré de similitude augmente lorsque la valeur de différences accumulées diminue.

2. Système de stockage d'énergie selon la revendication 1, dans lequel l'appareil de commande supérieur est configuré pour continuer à surveiller ou à commander la pluralité de batteries sans arrêter le fonctionnement du système de stockage d'énergie même si les informations d'état de la première batterie ne sont pas reçues du premier BMS en utilisant les informations d'état de la seconde batterie en tant qu'informations d'état de la première batterie.

3. Système de stockage d'énergie selon la revendication 1, dans lequel l'appareil de commande supérieur est configuré pour recevoir des informations d'état de la seconde batterie en provenance d'un second BMS parmi la pluralité de BMS pendant une période où les informations d'état de la première batterie ne sont pas reçues, et pour enregistrer les informations d'état reçues de la seconde batterie en tant qu'informations d'état de la première batterie.

4. Système de stockage d'énergie selon la revendication 1, dans lequel l'appareil de commande supérieur est configuré pour, lorsque l'état de charge, SOC, de la première batterie n'est pas reçu du premier BMS, sélectionner la seconde batterie parmi la pluralité de batteries sur la base d'informations historiques précédemment stockées des batteries et utiliser le SOC de la seconde batterie en tant que SOC de la première batterie.

5. Système de stockage d'énergie selon la revendication 4, dans lequel l'appareil de commande supérieur est configuré pour sélectionner la seconde batterie en utilisant des informations historiques concernant un ou plusieurs parmi des SOC, une quantité de charge/décharge cumulée et des valeurs de température de la pluralité de batteries.

6. Système de stockage d'énergie selon la revendication 5, dans lequel l'appareil de commande supérieur est configuré pour exclure des batteries ayant un historique de défaillance enregistré pendant une période prédéterminée d'une comparaison parmi les batteries autres que la première batterie.

7. Système de stockage d'énergie selon la revendication 5, dans lequel l'appareil de commande supérieur est configuré pour mettre à jour une batterie de la pluralité de batteries ayant une similitude immédiatement supérieure avec la première batterie en tant que seconde batterie, si une défaillance se produit dans la seconde batterie après sélection de la seconde batterie.

8. Système de stockage d'énergie selon la revendication 4, dans lequel l'appareil de commande supérieur est configuré pour :
lorsqu'un SOC de la première batterie n'est pas reçu,
identifier le tout dernier SOC de la première batterie ;
vérifier si le tout dernier SOC identifié se situe dans une plage de SOC seuil prédéfinie comme une section d'estimation SOC impossible, dans lequel la section d'estimation SOC impossible est une section de SOC supérieure à 10 et inférieure à 90 ; et
déterminer une batterie parmi la pluralité de batteries ayant la plus grande similitude avec les informations historiques de SOC de la première batterie en tant que seconde batterie, si le tout dernier SOC identifié de la première batterie est en dehors de la plage de SOC seuil.

9. Système de stockage d'énergie selon la revendication 8, dans lequel l'appareil de commande supérieur est configuré pour :
lorsque le nombre de batteries parmi la pluralité de batteries ayant la plus grande similitude avec les informations historiques de SOC de la première batterie est de deux ou plus,
déterminer une batterie, parmi les deux batteries ou plus, présentant la plus grande similitude avec des informations historiques sur une ou plusieurs parmi une quantité de charge/décharge cumulée et une valeur de température de la première batterie en tant que seconde batterie.

10. Système de stockage d'énergie selon la revendication 8, dans lequel l'appareil de commande supérieur est configuré pour :
lorsque le tout dernier SOC identifié se situe dans la plage de SOC seuil,
déterminer une batterie de la pluralité de batteries ayant la plus grande similitude avec des informations historiques sur une ou plusieurs parmi une quantité de charge/décharge cumulée et une valeur de température de la première batterie en tant que seconde batterie.

11. Système de stockage d'énergie selon la revendication 10, dans lequel l'appareil de commande supérieur est configuré pour :
déterminer une batterie de la pluralité de batteries ayant la plus grande similitude avec les informations historiques sur la quantité de charge/décharge cumulée de la première batterie en tant que seconde batterie, et
lorsque le nombre de batteries parmi la pluralité de batteries ayant la plus grande similarité avec les informations historiques sur la quantité de charge/décharge cumulée de la première batterie est de deux ou plus, déterminer, parmi les deux batteries ou
plus, une batterie ayant la plus grande similitude avec les informations historiques sur la valeur de température de la première batterie en tant que seconde batterie.

12. Procédé de commande de batteries pour un appareil de commande de batteries (800) interagissant avec une pluralité de systèmes de gestion de batterie (200), BMS, associés chacun à une batterie respective d'une pluralité de batteries (100), le procédé comprenant :
la collecte d'informations d'état (S510) sur la pluralité de batteries auprès de la pluralité de BMS et la surveillance ou la commande (S520) de la pluralité de batteries sur la base des informations d'état collectées ;
lorsque les informations d'état d'une première batterie parmi la pluralité de batteries ne sont pas reçues (S530) d'un premier BMS parmi la pluralité de batteries en raison d'une perte de communication, la sélection d'une seconde batterie parmi les batteries restantes sur la base d'informations historiques précédemment stockées de la pluralité de batteries ; et
l'utilisation des informations d'état de la seconde batterie en tant qu'informations d'état de la première batterie,
dans lequel la sélection de la seconde batterie comprend :
la comparaison d'informations historiques de la première batterie avec des informations historiques de batteries autres que la première batterie et le calcul d'une différence entre des valeurs d'état pour chaque point temporel compris dans des données historiques d'informations historiques ;
l'accumulation des différences calculées au fil du temps pour chaque comparaison et, sur la base des différences accumulées, le calcul d'un degré de similitude avec la première batterie ; et
la détermination, en tant que seconde batterie, d'une batterie présentant le plus grand degré de similitude avec la première batterie, dans lequel le degré de similitude augmente lorsque la valeur de différences accumulées diminue.

13. Procédé selon la revendication 12, dans lequel l'utilisation des informations d'état de la seconde batterie en tant qu'informations d'état de la première batterie comporte la surveillance ou la commande (S560) de la pluralité de batteries sans arrêter le fonctionnement du système de stockage d'énergie même si les informations d'état de la première batterie ne sont pas reçues du premier BMS en utilisant les informations d'état de la seconde batterie en tant qu'informations d'état de la première batterie.

14. Procédé selon la revendication 12, dans lequel l'utilisation des informations d'état de la seconde batterie en tant qu'informations d'état de la première batterie comporte :
la réception d'informations d'état de la seconde batterie en provenance d'un second BMS parmi la pluralité de BMS pendant une période où les informations d'état de la première batterie ne sont pas reçues ; et
l'enregistrement des informations d'état reçues de la seconde batterie en tant qu'informations d'état de la première batterie.

15. Procédé selon la revendication 12, dans lequel la sélection de la seconde batterie comporte, lorsque l'état de charge, SOC, de la première batterie n'est pas reçu du premier BMS, la sélection de la seconde batterie parmi la pluralité de batteries sur la base des informations historiques précédemment stockées des batteries, et
dans lequel l'utilisation des informations d'état de la seconde batterie en tant qu'informations d'état de la première batterie comporte l'utilisation du SOC de la seconde batterie en tant que SOC de la première batterie.

16. Procédé selon la revendication 15, dans lequel la sélection de la seconde batterie comporte la sélection de la seconde batterie à l'aide d'informations historiques comportant un ou plusieurs parmi des SOC, une quantité de charge/décharge cumulée et des valeurs de température des batteries.

17. Procédé selon la revendication 16, dans lequel la sélection d'une seconde batterie comporte l'exclusion de batteries ayant un historique de défaillance enregistré pendant une période prédéterminée d'une comparaison avec les batteries autres que la première batterie.

18. Procédé selon la revendication 16, comprenant en outre la mise à jour d'une batterie parmi la pluralité de batteries ayant une similitude immédiatement supérieure avec la première batterie en tant que seconde batterie, si une défaillance se produit dans la seconde batterie après sélection de la seconde batterie.

19. Procédé selon la revendication 15, dans lequel la sélection de la seconde batterie comporte :
lorsqu'un SOC de la première batterie n'est pas reçu, l'identification du tout dernier SOC de la première batterie ;
la vérification si le tout dernier SOC identifié se situe dans une plage de SOC seuil prédéfinie comme une section d'estimation SOC impossible, dans lequel la section d'estimation SOC impossible est une section de SOC supérieure à 10 et inférieure à 90 ; et
la détermination d'une batterie parmi la pluralité de batteries ayant la plus grande similitude avec les informations historiques de SOC de la première batterie en tant que seconde batterie, si le tout dernier SOC identifié de la première batterie est en dehors de la plage de SOC seuil.

20. Procédé selon la revendication 19, dans lequel la sélection de la seconde batterie comporte en outre :
lorsque le nombre de batteries ayant la plus grande similitude avec les informations historiques de SOC de la première batterie est de deux ou plus,
la détermination d'une batterie, parmi les deux batteries ou plus, présentant la plus grande similitude avec des informations historiques sur une ou plusieurs parmi une quantité de charge/décharge cumulée et une valeur de température de la première batterie en tant que seconde batterie.

21. Procédé selon la revendication 19, dans lequel la sélection de la seconde batterie comporte :
lorsque le tout dernier SOC identifié se situe dans la plage de SOC seuil,
la détermination d'une batterie de la pluralité de batteries ayant la plus grande similitude avec les informations historiques sur une ou plusieurs parmi une quantité de charge/décharge cumulée et une valeur de température de la première batterie en tant que seconde batterie.

22. Procédé selon la revendication 21, dans lequel la sélection de la seconde batterie comporte :
la détermination d'une batterie de la pluralité de batteries ayant la plus grande similitude avec les informations historiques sur la quantité de charge/décharge cumulée de la première batterie en tant que seconde batterie, et
lorsque le nombre de batteries ayant la plus grande similitude avec les informations historiques sur la quantité de charge/décharge cumulée de la première batterie est de deux ou plus, la détermination, parmi les deux batteries ou plus, d'une batterie de la pluralité de batteries ayant la plus grande similitude avec les informations historiques sur la valeur de température de la première batterie en tant que seconde batterie.
